# EUROPEAN PATENT SPECIFICATION

(11) **EP 3 477 780 B1**
(45) Date of publication and mention of the grant of the patent: **23.04.2025**
(21) Application number: 17833278.9
(22) Date of filing: 27.04.2017
(51) Int. Cl.: H01R 13/506, H01R 13/504, H01R 13/28, H01R 24/60, H01R 107/00

(54) **MOBILE TERMINAL, POWER ADAPTOR, AND POWER INTERFACE AND MANUFACTURING METHOD THEREFOR**
MOBILES ENDGERÄT, NETZADAPTER UND LEISTUNGSSCHNITTSTELLE SOWIE HERSTELLUNGSVERFAHREN DAFÜR
TERMINAL MOBILE, ADAPTATEUR DE PUISSANCE ET INTERFACE DE PUISSANCE ET LEUR PROCÉDÉ DE FABRICATION

(30) Priority: 27.07.2016 CN 201620803045 U; 27.07.2016 CN 201610605836
(43) Date of publication of application: 01.05.2019
(73) Proprietor: GUANGDONG OPPO MOBILE TELECOMMUNICATIONS CORP., LTD., Dongguan, Guangdong 523860 (CN)
(72) Inventor: GU, Guodong, Dongguan Guangdong 523860 (CN); LI, Feifei, Dongguan Guangdong 523860 (CN)
(74) Representative: Manitz Finsterwald Patent- und Rechtsanwaltspartnerschaft mbB
(86) International application number: PCT/CN2017/082260
(87) International publication number: WO 2018/018972

(56) References cited:
- WO-A1-2015/113340
- CN-A- 102 683 984
- CN-A- 102 683 984
- CN-A- 104 752 888
- CN-A- 104 882 705
- CN-A- 105 356 097
- CN-A- 105 449 398
- CN-A- 105 655 787
- CN-A- 106 025 672
- CN-U- 205 882 211
- CN-U- 205 882 229
- CN-U- 205 960 247
- US-A1- 2014 087 576
- US-B1- 9 350 128

## Description

### TECHNICAL FIELD

The described embodiments relate to communication technology, and in particular to a mobile terminal, a power adapter, a power interface, and a method for manufacturing the power interface.

### BACKGROUND

With the continuous improvement of living conditions, mobile phones have become essential communication tools for people. In order to meet the requirements of users and improve the market competitiveness of the mobile phones, on one hand, researchers and developers continue to improve the performance of mobile phones; on the other hand, researchers and developers continue to improve and optimize the appearance of mobile phones. Charging sockets are important components for the mobile phones. On one hand, when charging the mobile phones, the mobile phones need to be charged via the charging sockets; on the other hand, it is possible to achieve data transmission between the mobile phones and other devices by means of the charging sockets.

Chinese patent application CN102683984A provides an electric connector. The electric connector comprises an insulation body and multiple conductive terminals which are contained in the insulation body, wherein the insulation body is externally coated with a non-metal shell, and an inserting opening is formed by surrounding the non-metal shell and the insulation body. In such a way, a shell is made from a non-metal material, the electromagnetic interference cannot be caused for the radio frequency of a mobile device, the call quality can be ensured, and thus the defects of the prior art can be overcome. In addition, a grounding terminal is inserted into the tail end of the insulation body, the grounding terminal stretches into the inserting opening and is suspended at the inner wall surface of the non-metal shell, the grounding terminal is contacted with the shell of a USB (Universal Serial Bus) plug when a butt-joint USB plug is inserted in the inserting opening, and thus the grounding function of a metal shell in an original product can be replaced.

Chinese patent application CN105449398A provides an electrical connector with a terminal module enclosed within an insulative shield wherein the terminal module includes a plurality of terminals embedded within an insulative main body. The insulative main body forms a rear mounting standing part and a front mating tongue part extending forwardly from the rear mounting standing part. The insulative shield forms a rearward step against a forward shoulder of the base portion so as to prevent further forward movement of the base portion relative to the insulative shield. The insulative main body forms a protrusion and the insulative shield forms a securing hole to receive said protrusion for securing the insulative shield and the terminal module together.

US patent application US2014/087576A1 provides an electrical connector, comprises: an insulative housing; a plurality of contacts received into the insulative housing and having a plurality of soldering portion extending rearwardly and beyond a rear surface of the insulative housing; a metallic shell enclosing the insulative housing; and a cover formed on a rear end of the insulative housing and the metallic shell and sealed the rear surface of the insulative housing.

PCT patent application WO2015/113340A1 provides a USB interface and a mobile terminal comprising the USB interface. The mobile terminal is capable of driving other mobile terminals through the USB interface. The USB interface comprises: a USB interface body (1), a power line plug (3) externally connected to power lines through insertion parts, and a ground line plug (7) externally connected to ground lines through insertion parts. The edge of a bottom (32) of the power line plug and the edge of a bottom (72) of the ground line plug are fixed to the USB interface body. The power line plug has P insertion parts, and P is greater than or equal to 2; the ground line plug has Q insertion parts, and Q is greater than or equal to 2. The USB interface supports charging with a current greater than 3 amperes.

US patent application US20170207581A1 provides an electrical connector includes: an insulative housing including a base and a tongue; an upper and lower rows of contacts secured in the insulative housing and exposed to the tongue; a shielding shell enclosing the insulative housing; and a metal plate situated between the upper row of contacts and the lower rows of contacts; wherein the shielding shell is integrally formed with the metal plate. A related method of making such an electrical connector includes the steps of: inserting a first and second terminal modules into a first and second receiving spaces of a shielding shell, respectively, from a rear of the shielding shell; and insert molding the first and second terminal modules with a planar portion of a metal plate integral with the shielding shell.

### SUMMARY OF THE DISCLOSURE

The present disclosure is at least to some extent to solve one of the technical problems in the related art. Therefore, the present disclosure provides a mobile terminal, a power adapter, a power interface, and a method for manufacturing the power interface, as set out in the appended set of claims, which may have an advantage of high reliability.

In the power interface of the embodiment of the present disclosure, by arranging the first baffle in the plug shell and arranging the snap-fit flange on the plug body, and fixing the snap-fit flange in the plug shell by the first baffle and the second baffle, the plug body can be fixed in the plug shell to prevent the plug body from moving in an up-down direction of the plug shell, and the plug body can be prevented from being separated from the plug shell. Therefore, when a connection line of a power adapter is inserted into the power interface, the reliability of the connection between the connection line and the power interface may be improved.

### BRIEF DESCRIPTION OF THE DRAWINGS

FIG. 1 is an explosive view of a power interface according to an embodiment of the present disclosure.
FIG 2 is a partially enlarged view of portion A of FIG. 1.
FIG. 3 is a structural view of an intermediate patch in the power interface according to some embodiments of the present disclosure.
FIG. 4 is a cutaway view of the power interface according to some embodiments of the present disclosure.
FIG. 5 is a cutaway view of the power interface viewing in another angle according to some embodiments of the present disclosure.
FIG. 6 is a cutaway view of the power interface viewing in yet another angle according to some embodiments of the present disclosure.
FIG. 7 is a cutaway view of the power interface viewing in a further angle according to some embodiments of the present disclosure.
FIG. 8 is a partially enlarged view of portion B of FIG. 7.
FIG. 9 is a cutaway view of the power interface viewing in still a further angle according to some embodiments of the present disclosure.
FIG. 10 is a partially enlarged view of portion C of FIG. 9.
FIG. 11 is a structural view of a sub-pin of the power interface according to some embodiments of the present disclosure.

### List of reference numbers in drawings:

power interface 100,
plug shell 1, first baffle 11, stopping protrusion 111,
plug body 2, power pin 21, sub-pin 211, expanded portion 2111, and recess 2112,
data pin 22,
intermediate patch 23, through hole 231, reinforcing rib 232, reinforcing protrusion 233, notch 234, crimping 235, widened portion 236,
encapsulation member 24, first encapsulation portion 241, embedding protrusion 2411,
second encapsulation portion 242, receiving groove 2421, snap-fit flange 2422,
engaging groove 2423,
circuit board 25, first pad 251, second pad 252,
second baffle 3, gap 31.

### DETAILED DESCRIPTION

Embodiments of the present disclosure will be described in detail below, and examples of the embodiments will be illustrated in the accompanying drawings. The embodiments described below with reference to the drawings are illustrative and are intended to explain the present disclosure, and cannot be construed as a limitation to the present disclosure.

In the description of the present disclosure, it is to be understood that terms such as "up", "down", "front", "rear", "left", "right", "top", "bottom", "inner", "outer", "circumferential", and the like, refer to the orientations and locational relations illustrated in the accompanying drawings. Thus, these terms used here are only for describing the present disclosure and for describing in a simple manner, and are not intended to indicate or imply that the device or the elements are disposed to locate at the specific directions or are structured and performed in the specific directions, which could not to be understood as limiting the present disclosure.

In addition, terms such as "first", "second", and the like are used herein for purposes of description, and are not intended to indicate or imply relative importance or significance or to imply the number of indicated technical features. Thus, the feature defined with "first", "second", and the like may include one or more of such a feature. In the description of the present disclosure, "a plurality of" means two or more, such as two, three, and the like, unless specified otherwise.

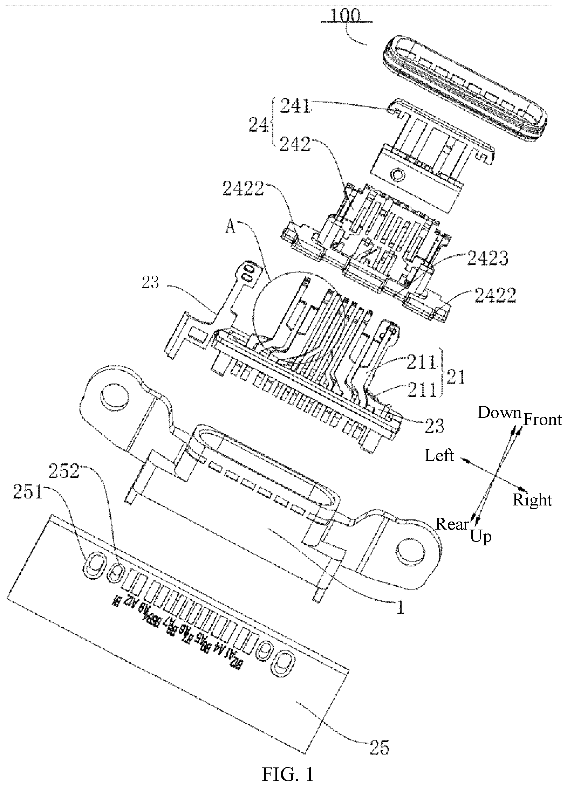

In the present disclosure, unless specified or limited, otherwise, terms "mounted", "connected", "coupled", "arranged", and the like are used in a broad sense, and may include, for example, fixed connections, detachable connections, or integral connections; may also be mechanical or electrical connections; may also be direct connections or indirect connections via intervening structures; may also be inner communications of two elements, as can be understood by one skilled in the art depending on specific contexts. In the following, a power interface 100 may be will be described in embodiments of the present disclosure with reference to FIGS. 1-11. It should be understood that, the power interface 100 includes an interface configured for charging or data transmission, and may be arranged in a mobile terminal such as a mobile phone, a tablet computer, a laptop, or any other suitable mobile terminal having a rechargeable function. The power interface 100 may be electrically connected to a corresponding power adapter to achieve a communication of electrical signals and data signals.

FIGS. 1-11 illustrate the power interface 100. The power interface 100 according to an embodiment of the present disclosure includes a plug shell 1, a plug body 2, and may include intermediate patch 23.

Specifically, a first baffle 11 is le arranged in the plug shell 1. The plug body 2 is arranged in the plug shell 1. An snap-fit flange 2422 is arranged on the plug body 2. A second baffle 3 is arranged in the plug shell 1, connected to the plug shell 1 and spaced apart from the first baffle 11. The snap-fit flange 2422 is sandwiched between the first baffle 11 and the second baffle 3. In this way, the snap-fit flange 2422 is fixed in the plug shell 1 by the first baffle 11 and the second baffle 3, and the plug body 2 is fixed in the plug shell 1. Thus, the plug body 2 may be prevented from moving in an up-down direction of the plug shell 1 to prevent the plug body 2 from being separated from the plug shell 1. Therefore, when a connection line of a power adapter is inserted into the power interface 100, the reliability of the connection between the connection line and the power interface 100 may be improved.

It should be noted that, the power interface 100 may be arranged on a mobile terminal, and a battery can be arranged inside the mobile terminal (e.g., a mobile phone, a tablet computer, a notebook computer, etc.). The battery may be charged by an external power source via the power interface 100.

In the power interface 100 of the embodiment of the present disclosure, by arranging the first baffle 11 in the plug shell 1 and arranging the snap-fit flange 2422 on the plug body 2, and fixing the snap-fit flange 2422 in the plug shell 1 by the first baffle 11 and the second baffle 3, the plug body 2 can be fixed in the plug shell 1 to prevent the plug body 2 from moving in the up-down direction of the plug shell 1, and the plug body 2 can be prevented from being separated from the plug shell 1. Therefore, when a connection line of a power adapter is inserted into the power interface 100, the reliability of the connection between the connection line and the power interface 100 may be improved.

In some embodiments of the present disclosure, the plug shell 1 and the second baffle 3 may be made of metal, and the second baffle 3 may be welded on the plug shell 1. The plug shell 1 and the second baffle 3 made of metal may have a great structural strength. In this way, it is possible to enhance the structural strength of the power interface 100, and the power interface 100 may be prevented from being deformed after a long time of use or after frequent insertion and removal. In addition, since the inner space of the plug shell 1 is limited, when the second baffle 3 is welded on the plug shell 1, it is possible to simplify the processing and assembling processes, shorten manufacturing cycles, and reduce the manufacturing cost.

In one embodiment, the second baffle 3 may be made of stainless steel. In this way, it is possible to avoid the second baffle 3 from rusting, and thus the poor contact of the plug body 2 with a power adapter due to the rusting of the second baffle 3 may be prevented from occurring. Therefore, the reliability of the operation of the power interface 100 may be ensured.

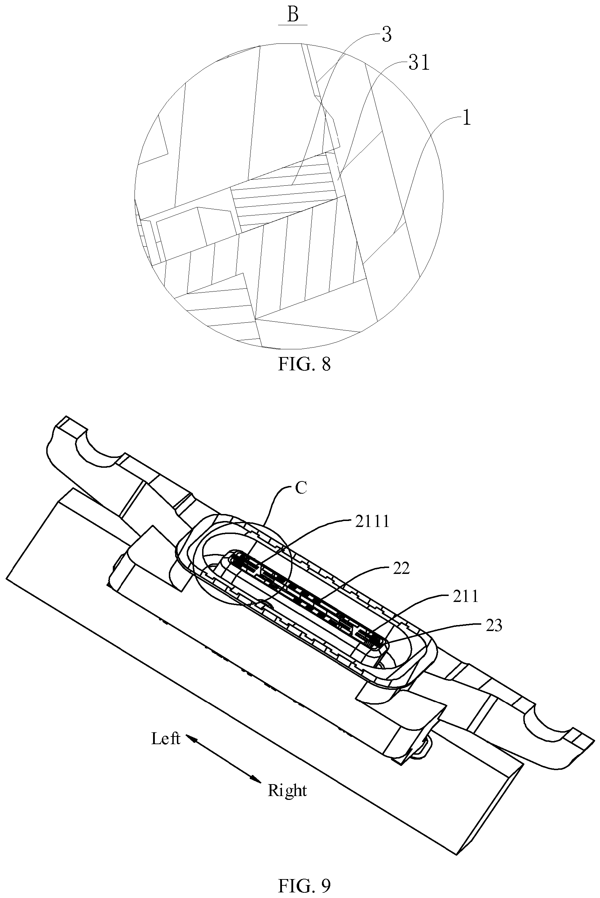

In some embodiments of the present disclosure, as shown in FIG. 8, a gap 31 may be defined between the second baffle 3 and the plug shell 1, and an adhesive layer may be arranged in the gap 31. On one hand, the adhesive layer may further bond the second baffle 3 with the plug shell 1, to improve the reliability of the connection between the second baffle 3 and the plug shell 1. On the other hand, the adhesive layer may have a waterproof function; that is, the adhesive layer may prevent liquid from entering the power interface 100 via an open end of the power interface 100 and damaging of the circuit board 25 inside the power interface 100, and the like, thereby ensuring the reliability of the power interface 100.

More specifically, the adhesive layer may be a dispensing layer. Dispensing is a process in which electronic glue, oil or other liquid may be applied to a product by means of painting, potting, or dripping, to allow the product to be adhesive, potted, insulated, fixed, and have a smooth face. On one hand, the dispensing layer may further bond the second baffle 3 with the plug shell 1 to improve the reliability of the connection between the second baffle 3 and the plug shell 1. On the other hand, the dispensing layer may have a waterproof function; that is, the dispensing layer may prevent liquid from entering the power interface 100 via an open end of the power interface 100 and damaging of the circuit board 25 inside the power interface 100, and the like, thereby ensuring the reliability of the power interface 100.

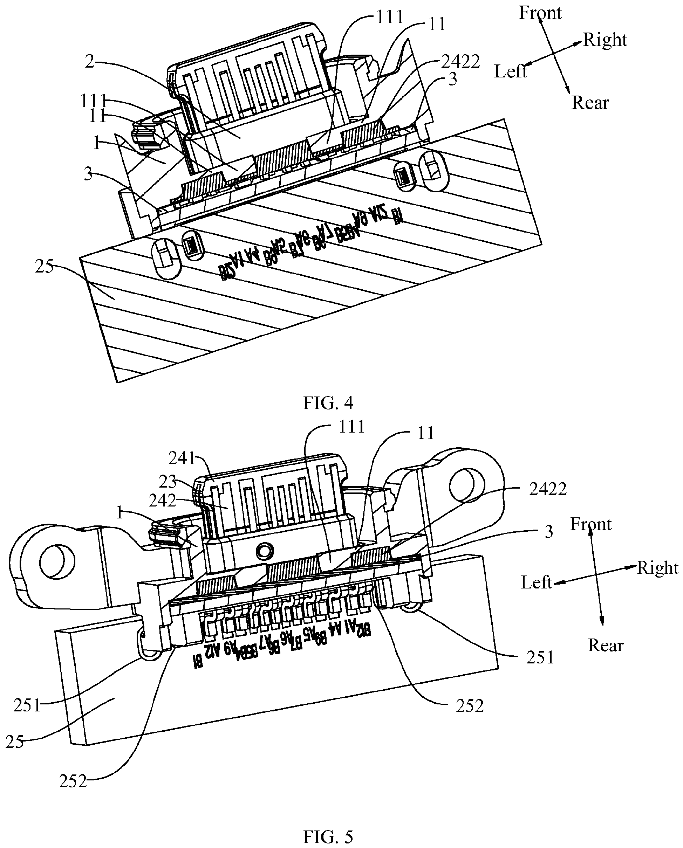

In some embodiments of the present disclosure, as shown in FIGS. 4-7, the second baffle 3 may extend in a circumferential direction of the plug body 2. On one hand, it is possible to improve the reliability of the connection between the second baffle 3 and the plug shell 1; on the other hand, it is also possible to enhance the fixing of the plug body 2 by the second baffle 3. In this way it is possible to ensure that the plug body 2 is securely fixed in the plug shell 1, and improve the reliability of the connection between a power line of a power adapter and the power interface 100.

Alternatively, a plurality of second baffles 3 may be provided, thereby facilitating the processing of the second baffle 3. It should be noted that, the plurality of second baffles 3 may be spaced apart from each other along the circumferential direction of the plug shell 1, and the plurality of second baffles 3 may also form an annular baffle. The plurality of second baffles 3 may be respectively connected to the plug shell 1, in order to fix the plug body 2.

In some embodiments of the present disclosure, as shown in FIGS. 4-7, the first baffle 11 may also extend in the circumferential direction of the plug body 2. In this way, it is possible to enhance the fixing of the plug body 2 by the first baffle 11. Alternatively, a stopping protrusion 111 may be arranged on a sidewall face of the first baffle 11 that faces towards the second baffle 3,and the stopping protrusion 111 may be engaged with the snap-fit flange 2422. In this way, the first baffle 11 and the second baffle 3 may prevent the plug body 2 from moving in the up-down direction in the plug shell 1, and may also prevent the plug body 2 from shaking in the plug shell 1 by the cooperation between the snap-fit flange 2422 and the stopping protrusion 111, and thus it is possible to ensure the reliability of the operation of the power interface 100.

Referring to FIG 1, the plug body 2 is configured to be connected to a circuit board 25, and includes at least a pair of power pins 21. In this embodiment, each pair of power pins includes two sub-pins 21 spaced apart from each other in an up-down direction (the up-down direction as shown in FIG 1). The intermediate patch 23 may be sandwiched between the two sub-pins 211, and configured to support the sub-pins 211. Therefore, it is possible to avoid poor contact between a connecting line and the power interface 100 caused by the movement of the two sub-pins 211 which are spaced apart from each other in the up-down direction towards each other when the connection line is inserted into the power interface. In this way, it is possible to ensure the reliability of the connection between the connection line and the power interface 100.

The intermediate patch 23 may have a head end close to a front end of the power pin 21 (the front end as shown in FIG. 1) and a tail end close to a rear end of the power pin 21 (the rear end as shown in FIG 1). .The tail end may be spaced apart from the plug shell 1 and connected to the plug body 2. When designing the tail end being spaced apart from the plug shell 1, it is possible to avoid producing interference with antenna signals, and thus the quality and the speed of signal transmission may be improved. In addition, both the tail end and the plug shell 1 may be connected to the plug body 2. In this way, the intermediate patch 23, the plug shell 1, and the plug body 2 may be connected to each other, thereby improving the reliability of the connection among the intermediate patch 23, the plug shell 1, and the plug body 2.

In some embodiments of the present disclosure, as shown in FIG. 1 and FIG 5, a plurality of first pads 251 and a plurality of second pads 252 may be arranged on the circuit board 25. Each of the plurality of first pads 251 and each of the plurality of second pads 252 may be spaced apart from each other may be arranged on the circuit board 25 of the plug body 2. The plug shell 1 may be welded on the first pad 251, and the tail end may be welded on the second pad 252. In this way, the plug shell 1 and the intermediate patch 23 may be connected to the circuit board 25, thereby firmly fixing the plug body 2 to the circuit board 25 and preventing the power pin 21 of the plug body 2 from falling off the circuit board 25, and thus the reliability of the operation of the power interface 100 may be ensured.

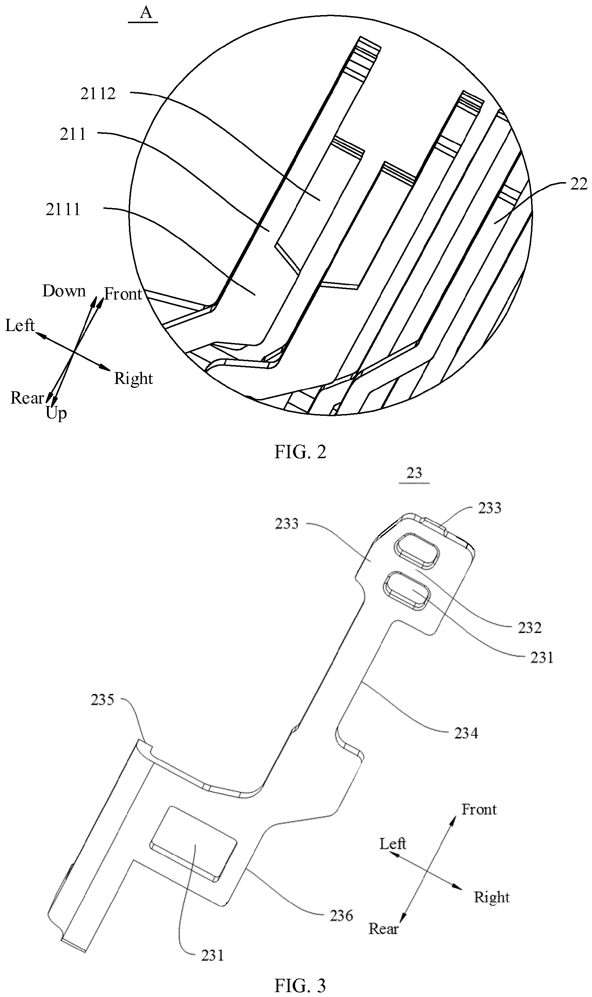

In some embodiments of the present disclosure, as shown in FIG 2, at least one sub-pin 211 includes an expanded portion 2111. The expanded portion 2111 has a cross-sectional area larger than that of a data pin 22 of the plug body 2. In this way, the current load of the sub-pins 211 can be increased, and the transmission speed of the current improved. In this way, the power interface 100 can have a fast charging function, thereby improving the charging efficiency of the battery.

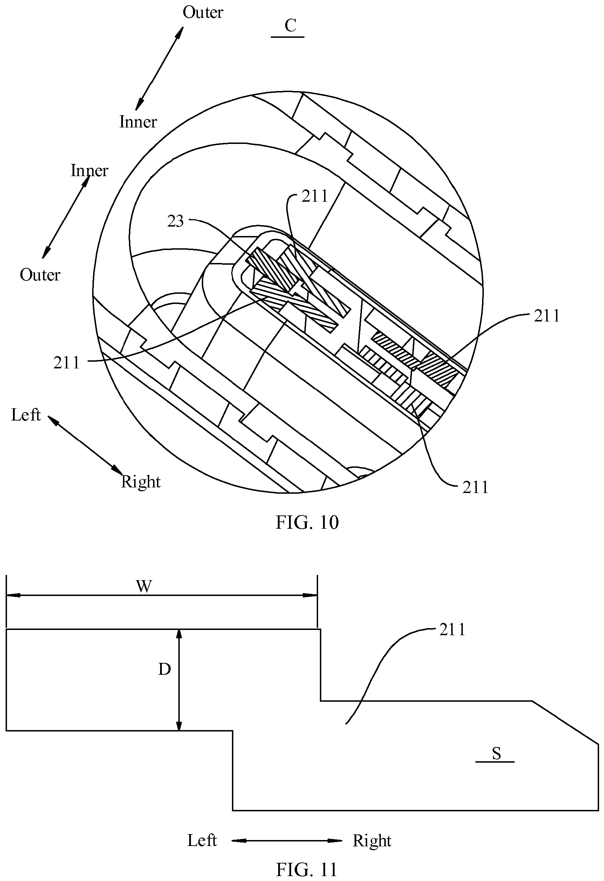

Optionally, as shown in FIG 11, the cross-sectional area of the expanded portion 2111 may be defined as S, and S ≥ 0.09805 mm2. It has been experimentally verified that when S ≥ 0.09805 mm2, the current load of the sub-pins 211 may be at least 10A. Therefore, the charging efficiency can be improved by increasing the current load of the sub-pins 211. After further tests, when S=0.13125 mm2, the current load of the sub-pins 211 may be 12A or more, which can improve charging efficiency.

Furthermore, as shown in FIG 11, a thickness of the sub-pin 211 may be defined as D, and 0.1 mm ≤ D ≤ 0.3 mm. It has been experimentally verified that when 0.1 mm ≤ D ≤ 0.3 mm, the current load of the sub-pins 211 is at least 10A. In this way, it is possible to improve the charging efficiency by increasing the current load of the sub-pins 211. After further tests, when D=0.25mm, the current load of the sub-pins 211 may be greatly increased, and the current load of the sub-pins 211 is 12A or more, thereby improving the charging efficiency.

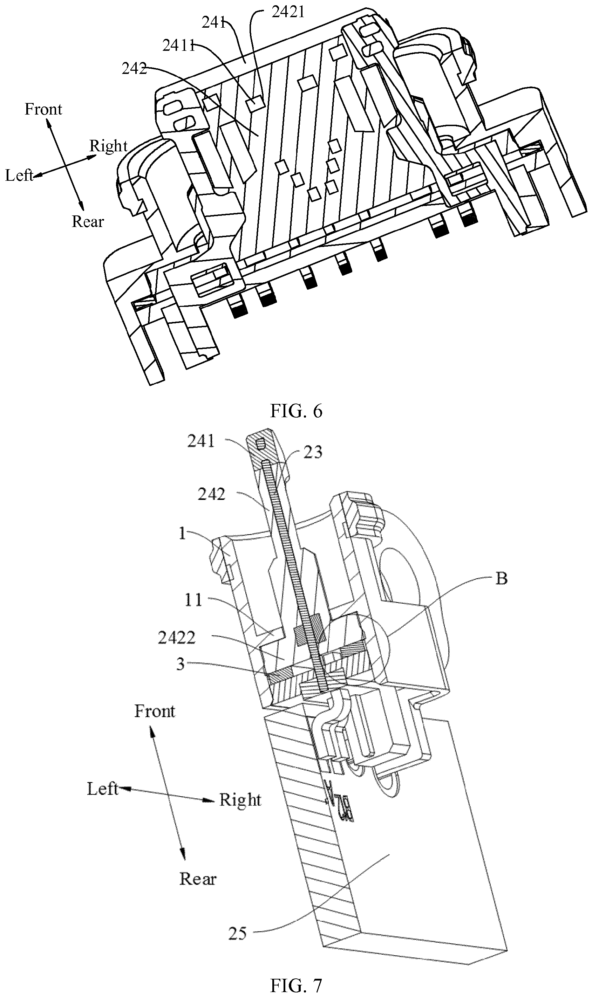

Referring to FIGS. 9-11, each sub-pin 211 may have a contact surface configured to be electrically connected to a power adapter. In a width direction of the sub-pin 211 (i.e. the left-right direction shown in FIG. 6), a width of the contact surface may be defined as W, which meets 0.24 mm ≤ W ≤ 0.32 mm. It has been experimentally verified that when 0.24 mm ≤ W ≤ 0.32 mm, the current load of the sub-pin 211 is at least 10 A. In this way, it is possible to improve the charging efficiency by increasing the current load of the sub-pins 211. After further tests, when W = 0.25 mm, the current load of the sub-pin 211 may be greatly increased, and the current load of the sub-pins 211 is 12A or more, thereby improving the charging efficiency.

According to some embodiments of the present disclosure, referring to FIG. 2, the expanded portion 2111 may be located in the middle of the sub-pin 211. In this way, the arrangement of the sub-pins 211 and the data pins 22 may be optimized, and the space of the power interface 100 may be fully utilized. Therefore, the compactness and the rationality of the configuration of the power interface 100 may be improved.

Furthermore, as shown in FIG 2, a recess 2112 is defined in the expanded portion 2111 at a position that is close to the front end of the sub-pin 211. It should be noted that, when the power interface 100 performs the fast charging function, the sub-pin 211 with the expanded portion 2111 is used to carry a large charging current. When the power interface 100 performs the normal charging function, the recess 2112 defined in the expanded portion 2111 prevents the sub-pin 211 from getting into contact with a corresponding pin of a power adapter. In this way, the power interface 100 in this embodiment can be applied to different power adapters. For example, when the power interface 100 performs the fast charging function, the power interface 100 can be electrically connected to a corresponding power adapter with the fast charging function. When the power interface 100 performs the normal charging function, the power interface 100 can be electrically connected to a corresponding normal power adapter. It should be noted that, the fast charging function herein may refer to a charging state in which the charging current is greater than or equal to 2.5A, and the normal charging may refer to a charging state in which the charging current is less than 2.5A.

In some embodiments of the present disclosure, as shown in FIGS. 1 and 5 and 6, the power interface 100 includes an encapsulation member 24, and the intermediate patch 23 and the plug body 2 are wrapped by the encapsulation member 24. The encapsulation member 24 may be made of electrically insulative and heat-conductive material. The encapsulation member 24 is configured to fix the intermediate patch 23, the power pins 21 and the data pins 22 of the plug body 2, thereby ensuring the reliability of the connection between the connection line of the power adapter and the power interface 100. The encapsulation member 24 includes a first encapsulation portion 241 and a second encapsulation portion 242. The first encapsulation portion 241 and the second encapsulation portion 242 match with and cooperate with each other. More specifically, the second encapsulation portion 242 may define a plurality of receiving grooves 2421, and a plurality of embedding protrusions 2411 may be arranged on the first encapsulation portion 241. The plurality of receiving grooves 2421 may be in one-to-one correspondence with the plurality of embedding protrusions 2411, and cooperate with the plurality of embedding protrusions 2411. In this way, the reliability of the connection between the first encapsulation portion 241 and the second encapsulation portion 242 may be improved.

As shown in FIG. 3, the head end may define a through hole 231, and a reinforcing rib 232 may be arranged in the through hole 231. In this way, it is possible to not only save the material of the intermediate patch 23, but also improve the structural strength of the intermediate patch 23 by arranging the reinforcing rib 232 in the through hole 231.

In some embodiments of the present disclosure, as shown in FIG. 3, the reinforcing rib 232 may extend in the left-right direction. In this way, the structural strength of the intermediate patch 23 may be enhanced. Of course, the present disclosure may not be limited thereto. For example, the reinforcing rib 232 may extend in the front-rear direction, or an extending direction of the reinforcing rib 232 may be at an angle to the left-right direction, as long as the structural strength of the intermediate patch 23 may be enhanced.

In some embodiments of the present disclosure, as shown in FIG. 3, a reinforcing protrusion 233 that protrudes away from the plug body 2 may be arranged at the head end. The reinforcing protrusion 233 may increase area of the contact surface between the intermediate patch 23 and the encapsulation member 24, enhance the adhesion between the intermediate patch 23 and the encapsulation member 24, and make the connection between the intermediate patch 23 and the encapsulation member 24 more stable. In this way, the intermediate patch 23 and the plug body 2 may be better fixed together by the encapsulation member 24.

Alternatively, as shown in FIG. 3, the reinforcing protrusion 233 may be located on at least one of a side wall face and a front end face of the head end. For example, in the example shown in FIG. 3, the front end face of the head end may be provided with the reinforcing protrusion 233, and a left side wall face in the left of the head end may be also provided with the reinforcing protrusion 233. In this way, it is possible to increase the contact surface between the intermediate patch 23 and the encapsulation member 24, enhance the adhesion between the intermediate patch 23 and the encapsulation member 24, and make the connection between the intermediate patch 23 and the encapsulation member 24 more stable. In this way, the intermediate patch 23 and the plug body 2 may be better fixed together by the encapsulation member 24.

As shown in FIG. 3, in order to increase the flexibility of the intermediate patch 23, a notch 234 may be defined in the middle of the intermediate patch 23. In this way, when the intermediate patch 23 is shifted upwardly or downwardly, the intermediate patch 23 may quickly return back to the original position due to the notch 234, which facilitates the connection between the connection line of the power adapter and the power interface 100 next time.

In some embodiments of the present disclosure, as shown in FIG 3, a crimping 235 may be arranged at the tail end, and one of the pair of power pins 21 may be configured to be wrapped by the crimping 235. On one hand, the crimping 235 may increase the contact area between the intermediate patch 23 and the encapsulation member 24, enhance the adhesion between the intermediate patch 23 and the encapsulation member 24, and make the connection between the intermediate patch 23 and the encapsulation member 24 more stable, thereby better fixing the intermediate patch 23 and the plug body 2 together by the encapsulation member 24. On the other hand, the crimping 235 may provide a protection to the power pin 21.

In addition, as shown in FIG 3, the tail end may define a through hole 231. In this way, it is possible to further save the material of the intermediate patch 23. Of course, in order to ensure the structural strength of the intermediate patch 23, a reinforcing rib 232 may also be arranged in the through hole 231.

Referring to FIGS. 1-11, the power interface 100 according to embodiments of the present disclosure is described in details. It is noted that, the following description only is exemplary, and is not limitation to the present disclosure.

For convenience to describe, an example where the power interface 100 is implemented as a Type-C interface is described. The Type-C interface may also be called an USB Type-C interface. The Type-C interface belongs to a type of an interface, and is a new data, video, audio and power transmission interface specification developed and customized by the USB (Universal Serial Bus) standardization organization to solve the drawbacks present for a long time that the physical interface specifications of the USB interface are uniform, and that the power can only be transmitted in one direction.

The Type-C interface may have the following features: all devices supporting the Type-C interface, a standard device may declare its willing to occupy a VBUS (that is, a positive connection wire of a traditional USB) to another device through a CC (Configuration Channel) pin in the interface specification. The device having a stronger willing may eventually output voltages and currents to the VBUS, while the other device may accept the power supplied from the VBUS bus, or the other device may still refuse to accept the power; however, it does not affect the transmission function. In order to use the definition of the bus more conveniently, a Type-C interface chip (such as LDR6013) may generally classify devices into four types: DFP (Downstream-facing Port), Strong DRP (Dual Role Power), DRP, and UFP (Upstream-facing Port). The willingness of these four types to occupy the VBUS may gradually decrease.

The DFP may correspond to an adapter, and may continuously output voltages to the VBUS. The Strong DRP may correspond to a mobile power, and may give up outputting voltages to the VBUS only when the strong DRP encounters the adapter. The DRP may correspond to a mobile phone. Normally, the DRP may expect other devices to supply power to itself. However, when encountering a device that may have a weaker willingness, the DRP may also output the voltages and currents to the device. The UFP will not output electrical power externally. Generally, the UFP is a weak battery device, or a device without any batteries, such as a Bluetooth headset. The USB Type-C interface may support the insertions both from a positive side and a negative side. Since there are four groups of power sources and grounds on both sides (the positive side and the negative side), the power supported by USB Type-C interface may be greatly improved.

The power interface 100 in this embodiment may be applied to a power adapter with the fast charging function, or a normal power adapter. The fast charging herein may refer to a charging state in which a charging current is greater than 2.5A. The normal charging herein may refer to a charging state in which the charging current is less than or equal to 2.5A. That is, when the power interface 100 is charged by the power adapter with the fast charging function, the charging current is greater than or equal to 2.5A, or the rated output power is no less than 15W. When the power interface 100 is charged by the normal power adapter, the charging current is less than 2.5A, or the rated output power is less than 15W.

More specifically, as shown in FIGS. 1-8, the power interface 100 includes a plug shell 1, a plug body 2, an intermediate patch 23, and an encapsulation member 24. The plug body 2 may be arranged in the plug shell 1, configured to be connected to the circuit board 25, and may include four pairs of power pins 21. Each pair of power pins 21 includes two sub-pins 21 spaced apart from each other in the up-down direction. The intermediate patch 23 may be sandwiched between the two sub-pins 211, such that it is possible to avoid poor contact between the connecting line and the power interface 100 caused by the movement of the two sub-pins 211 which are spaced apart from each other in the up-down direction towards each other. The intermediate patch 23 and the plug body 2 are wrapped by the encapsulation member 24.

In this case, the encapsulation member 24 may be made of electrically insulative and heat-conductive material. The encapsulation member 24 is configured to fix the intermediate patch 23, the power pins 21 and the data pins 22 of the plug body 2, thereby ensuring the reliability of the connection between the connection line of the power adapter and the power interface 100. As shown in FIGS. 1, 5 and 6, the encapsulation member 24 includes a first encapsulation portion 241 and a second encapsulation portion 242. The second encapsulation portion 242 may define a plurality of receiving groove 2421, and the first encapsulation portion 241 may include a plurality of embedding protrusions 2411. The plurality of receiving grooves 2421 may be in one-to-one correspondence with the plurality of embedding protrusions 2411, and cooperate with the plurality of embedding protrusions 2411. In this way, the reliability of the connection between the first encapsulation portion 241 and the second encapsulation portion 242 may be improved.

As shown in FIG. 3, the intermediate patch 23 may have a head end close to a front end of the power pin 21 and a tail end close to a rear end of the power pin 21. The head end may define a through hole 231, and a reinforcing rib 232 may be arranged in the through hole 231. The reinforcing rib 232 may extend in the left-right direction. In this way, the material of the intermediate patch 23 may be saved, and the structural strength of the intermediate patch 23 may be enhanced. The head end and the left side wall face may have a reinforcing protrusion 233 that protrudes away from the plug body 2. The reinforcing protrusion 233 may increase the area of the contact surface between the intermediate patch 23 and the encapsulation member 24, enhance the adhesion between the intermediate patch 23 and the encapsulation member 24, and make the connection between the intermediate patch 23 and the encapsulation member 24 more stable. In this way, the intermediate patch 23 and the plug body 2 may be better fixed together by the encapsulation member 24.

As shown in FIG. 3, a notch 234 may be defined in the middle of the intermediate patch 23. In this way, when the intermediate patch 23 is shifted upwardly or downwardly, the intermediate patch 23 may quickly return back to the original position. A crimping 235 may be arranged at the tail end, and one of the pair of power pins 21 may be configured to be wrapped by the crimping 235. The crimping 235 may increase the contact surface between the intermediate patch 23 and the encapsulation member 24, and provide a protection to the power pin 21. The tail end may have a widened portion 236, and the widened portion 236 may define a through hole 231, which further saves the material of the intermediate patch 23.

In addition, as shown in FIG. 1, FIG 5 and FIG 6, the tail end may be spaced apart from the plug shell 1 and connected to the plug body 2. In this way, it is possible to avoid producing interference with the antenna signals, and thus the quality and the speed of signal transmission may be ensured. A plurality of first pads 251 and a plurality of second pads 252 may be arranged on the circuit board 25. Each of the plurality of first pads 251 and each of the plurality of second pads 252 may be spaced apart from each other may be arranged on the circuit board 25 of the plug body 2. The plug shell 1 may be welded on the first pad 251, and the tail end may be welded on the second pad 252. In this way, the plug shell 1 and the intermediate patch 23 may be connected to the circuit board 25, thereby firmly fixing the plug body 2 to the circuit board 25 and preventing the power pins 21 of the plug body 2 from separating from the circuit board 25, and thus the reliability of the operation of the power interface 100 may be ensured.

As shown in FIG 2, at least one sub-pin 211 includes an expanded portion 2111. The expanded portion 2111 has a cross-sectional area larger than that of a data pin 22 of the plug body 2. In this way, the current load of the sub-pins 211 is increased, and the transmission speed of the current is improved. A recess 2112 is defined in the expanded portion 2111 at a position that is close to the front end of the sub-pin 211. When the power interface 100 performs the fast charging function, the sub-pin 211 with the expanded portion 2111 is used to carry a large charging current. When the power interface 100 performs the normal charging function, the recess 2112 on the expanded portion 2111 prevents the sub-pin 211 from getting into contact with a corresponding pin of a power adapter.

In this case, as shown in FIG. 11, a thickness of the sub-pin 211 may be defined as D, and the cross-sectional area of the expanded portion 2111 may be defined as S. It has been experimentally verified that, when D=0.25 mm and S=0.13125 mm2, the current load of the sub-pins 211 is at least 12A, thereby improving the charging efficiency. Furthermore, as shown in FIG 11, when W = 0.25 mm, the current load of the sub-pins 211 is at least 14A, thereby improving the charging efficiency.

Furthermore, as shown in FIGS. 4-8, a first baffle 11 is arranged in the plug shell 1, and an snap-fit flange 2422 is arranged on the second encapsulation portion 242. The power interface 100 further includes a second baffle 3. The second baffle 3 is arranged in the plug shell 1, connected to the plug shell 1, and spaced apart from the first baffle 11. The snap-fit flange 2422 is sandwiched between the first baffle 11 and the second baffle 3. In this way, the second encapsulation portion 242 is fixed in the plug shell 1 by the first baffle 11 and the second baffle 3, thereby fixing the plug body 2 in the plug shell 1, and preventing the plug body 2 from moving in the up-down direction of the plug shell 1.

In this case, the first baffle 11 and the second baffle 3 may be made of metal, and the second baffle 3 may be made of stainless steel. The second baffle 3 may be connected to the plug shell 1 by means of spot welding. The plug shell 1 and the second baffle 3 made of metal may have a great structural strength. In this way, it is possible to enhance the structural strength of the power interface 100. In addition, since the inner space of the plug shell 1 is limited, when the second baffle 3 is welded on the plug shell 1, it is possible to simplify the processing and assembling processes, shorten manufacturing cycles, and reduce the manufacturing cost. A gap 31 may be defined between the second baffle 3 and the plug shell 1, and a dispensing layer may be arranged in the gap 31. On one hand, the dispensing layer may further bond the second baffle 3 with the plug shell 1 to improve the reliability of the connection between the second baffle 3 and the plug shell 1. On the other hand, the dispensing layer may have a waterproof function; that is, the dispensing layer may prevent liquid from entering the power interface 100 via an open end of the power interface 100 and damaging of the circuit board 25 inside the power interface 100, and the like, thereby ensuring the reliability of the power interface 100. In this embodiment, a pair of second baffles 3 may be provided. The pair of second baffles 3 may extend in the circumferential direction of the plug shell 1. The pair of second baffles 3 may form an annular baffle. In this way, the reliability of the connection between the second baffle 3 and the plug shell 1 may be enhanced, and the structure of the second baffle 3 may be simplified.

The first baffle 11 may also extend in the circumferential direction of the plug body 2. In this way, it is possible to enhance the fixing of the plug body 2 by the first baffle 11. A stopping protrusion 111 may be arranged on a sidewall face of the first baffle 11 that faces towards the second baffle 3, and the stopping protrusion 111 may be engaged in engaging groove 2423 between two adjacent snap-fit flanges 2422. In this way, it is possible to prevent the plug body 2 from shaking in the plug shell 1 by the cooperation between the snap-fit flange 2422 and the stopping protrusion 111, and thus it is possible to ensure the reliability of the operation of the power interface 100.

A method for manufacturing the power interface 100 according to an embodiment of the present disclosure will now be described with reference to FIGS. 1-11. Herein, the power interface 100 is the power interface 100 described above.

The method for manufacturing the power interface 100 according to an embodiment of the present disclosure comprises:
S10: processing a plug shell (1), wherein a first baffle (11) is arranged in the plug shell (1); S20: mounting a plug body (2) into the plug shell (1), wherein the plug body (2) is wrapped by an encapsulation member (24); the encapsulation member (24) comprises a first encapsulation portion (241) and a second encapsulation portion (242), and the first encapsulation portion (241) and the second encapsulation portion (242) are configured to match with and cooperate with each other; a snap-fit flange (2422) disposed on the second encapsulation portion (242) is arranged on the plug body (2),
S30: welding a second baffle (3) on an inner face of the plug shell (1), wherein the second baffle (3) is spaced apart from the first baffle (11), the snap-fit flange (2422) is sandwiched between the first baffle (11) and the second baffle (3); wherein the plug body (2) is configured to be connected to a circuit board (25) and comprises at least one pair of power pins (21) and a plurality of data pins (22), and each pair of power pins (21) comprises a pair of sub-pins (211) spaced apart from each other in an up-down direction; the encapsulation member (24) is configured to fix the at least one pair of power pins (21) and the plurality of data pins (22); characterized in that at least one of the pair of sub-pins (211) comprises an expanded portion (2111), and the expanded portion (2111) has a cross-sectional area larger than that of each of the plurality of data pins (22) of the plug body (2) to increase a current load of the at least one of the pair of sub-pins (211); a recess (2112) is defined in the expanded portion (2111) at a position that is close to an end of the at least one of the pair of sub-pins (211) away from the second baffle (3).

The plug shell 1 at the S10 may be an injection molded part, and the first baffle 11 may be injected on the inner face of the plug shell 1, which may facilitate the processing of the plug shell 1 and the first baffle 11. At the S30, the second baffle 3 may be connected to the plug shell 1 by means of spot welding. The spot welding may be a quick and economical connection method in which the weldments may be welded to each other on the contact surface at the joint between the weldments by individual welding spots.

Furthermore, a gap 31 may be defined between the second baffle 3 and the plug shell 1. The method for manufacturing the power interface 100 may further include: arranging an adhesive layer in the gap 31, such that the second baffle 3 and the plug shell may be closely bonded with each other, and liquid may be prevent from entering the power interface 100.

A mobile terminal according to an embodiment of the present disclosure includes the power interface 100 as described above. The mobile terminal realizes the transmission of electrical signals and data signals via the power interface 100. For example, the mobile terminal may be electrically connected to the power adapter through the power interface 100 to implement a charging or data transmission function.

In the mobile terminal according to an embodiment of the present disclosure, by arranging the first baffle 11 in the plug shell 1 and arranging the snap-fit flange 2422 on the plug body 2, and fixing the snap-fit flange 2422 in the plug shell 1 by the first baffle 11 and the second baffle 3, the plug body 2 can be fixed in the plug shell 1 to prevent the plug body 2 from moving in the up-down direction of the plug shell 1, and the plug body 2 can be prevented from being separated from the plug shell 1. Therefore, when a connection line of a power adapter is inserted into the power interface 100, the reliability of the connection between the connection line and the power interface 100 may be improved.

A power adapter according to an embodiment of the present disclosure includes the power interface 100 as described above. The mobile terminal realizes the transmission of electrical signals and data signals via the power interface 100.

In the power adapter according to an embodiment of present disclosure, by arranging the first baffle 11 in the plug shell 1 and arranging the snap-fit flange 2422 on the plug body 2, and fixing the snap-fit flange 2422 in the plug shell 1 by the first baffle11 and the second baffle 3, the plug body 2 can be fixed in the plug shell 1 to prevent the plug body 2 from moving in the up-down direction of the plug shell 1, and the plug body 2 can be prevented from being separated from the plug shell 1. Therefore, when a connection line of a power adapter is inserted into the power interface 100, the reliability of the connection between the connection line and the power interface 100 may be improved.

## Claims

1. A power interface for a mobile terminal, comprising:
a plug shell (1), wherein a first baffle (11) is arranged in the plug shell (1);
an encapsulation member (24), wherein the encapsulation member (24) comprises a first encapsulation portion (241) and a second encapsulation portion (242), and the first encapsulation portion (241) and the second encapsulation portion (242) are configured to match with and cooperate with each other;
a plug body (2), arranged in the plug shell (1) and wrapped by the encapsulation member (24), wherein a snap-fit flange (2422) disposed on the second encapsulation portion (242) is arranged on the plug body (2); and
a second baffle (3), located in the plug shell (1) and connected to the plug shell (1), wherein the second baffle (3) is spaced apart from the first baffle (11), the snap-fit flange (2422) is sandwiched between the first baffle (11) and the second baffle (3);
wherein the plug body (2) is configured to be connected to a circuit board (25) and comprises at least one pair of power pins (21) and a plurality of data pins (22), and each pair of power pins (21) comprises a pair of sub-pins (211) spaced apart from each other in an up-down direction; the encapsulation member (24) is configured to fix the at least one pair of power pins (21) and the plurality of data pins (22);
**characterized in that** at least one of the pair of sub-pins (211) comprises an expanded portion (2111), and the expanded portion (2111) has a cross-sectional area larger than that of each of the plurality of data pins (22) of the plug body (2) to increase a current load of the at least one of the pair of sub-pins (211);
a recess (2112) is defined in the expanded portion (2111) at a position that is close to an end of the at least one of the pair of sub-pins (211) away from the second baffle (3).

2. The power interface of claim 1, wherein a gap (31) is defined between the second baffle (3) and the plug shell (1), and an adhesive layer is arranged in the gap (31).

3. The power interface of any one of claims 1-2, wherein the second baffle (3) extends along a circumferential direction of the plug body (2).

4. The power interface of any one of claims 1-3, comprising a plurality of second baffles (3).

5. The power interface of any one of claims of 1-4, wherein the first baffle (11) extends along a circumferential direction of the plug body (2).

6. The power interface of any one of claims 1-5, wherein a stopping protrusion (111) is arranged on a sidewall face of the first baffle (11) facing towards the second baffle (3), and the stopping protrusion (111) is engaged with the snap-fit flange (2422).

7. The power interface of any one of claims 1, wherein the expanded portion (2111) is located in a middle of the at least one of the pair of sub-pins (211).

8. A method for manufacturing a power interface for a mobile terminal, comprising:
S10: processing a plug shell (1), wherein a first baffle (11) is arranged in the plug shell (1);
S20: mounting a plug body (2) into the plug shell (1), wherein the plug body (2) is wrapped by an encapsulation member (24); the encapsulation member (24) comprises a first encapsulation portion (241) and a second encapsulation portion (242), and the first encapsulation portion (241) and the second encapsulation portion (242) are configured to match with and cooperate with each other; a snap-fit flange (2422) disposed on the second encapsulation portion (242) is arranged on the plug body (2); and
S30: welding a second baffle (3) on an inner face of the plug shell (1), wherein the second baffle (3) is spaced apart from the first baffle (11), the snap-fit flange (2422) is sandwiched between the first baffle (11) and the second baffle (3);
wherein the plug body (2) is configured to be connected to a circuit board (25) and comprises at least one pair of power pins (21) and a plurality of data pins (22), and each pair of power pins (21) comprises a pair of sub-pins (211) spaced apart from each other in an up-down direction; the encapsulation member (24) is configured to fix the at least one pair of power pins (21) and the plurality of data pins (22);
**characterized in that** at least one of the pair of sub-pins (211) comprises an expanded portion (2111), and the expanded portion (2111) has a cross-sectional area larger than that of each of the plurality of data pins (22) of the plug body (2) to increase a current load of the at least one of the pair of sub-pins (211);
a recess (2112) is defined in the expanded portion (2111) at a position that is close to an end of the at least one of the pair of sub-pins (211) away from the second baffle (3).

9. The method of claim 8, wherein at the S10, the plug shell (1) is an injection molded part, and the first baffle (11) is injected on the inner face of the plug shell (1).

10. The method of any one of claims 8-9, wherein at the S30, a gap (31) is defined between the second baffle (3) and the inner face of the plug shell (1), the method further comprises:
S40: arranging an adhesive layer in the gap (31).

11. A mobile terminal, **characterized in that** the mobile terminal comprises the power interface of any one of claims 1-7.

12. A power adapter for a mobile terminal, **characterized in that** the power adapter comprises the power interface of any one of claims 1-7.

## Patentansprüche

1. Leistungsschnittstelle für ein mobiles Endgerät, die Folgendes umfasst:
eine Steckerschale (1), wobei eine erste Ablenkplatte (11) in der Steckerschale (1) angeordnet ist;
ein Kapselungselement (24), wobei das Kapselungselement (24) einen ersten Kapselungsabschnitt (241) und einen zweiten Kapselungsabschnitt (242) umfasst und der erste Kapselungsabschnitt (241) und der zweite Kapselungsabschnitt (242) konfiguriert sind, miteinander zusammenzupassen und zusammenzuwirken;
einen Steckerkörper (2), der in der Steckerschale (1) angeordnet ist und durch das Kapselungselement (24) umwickelt ist, wobei ein Einrastflansch (2422), der auf den zweiten Kapselungsabschnitt (242) aufgebracht ist, am Steckerkörper (2) angeordnet ist; und
eine zweite Ablenkplatte (3), die in der Steckerschale (1) angeordnet ist und mit der Steckerschale (1) verbunden ist, wobei die zweite Ablenkplatte (3) von der ersten Ablenkplatte (11) beabstandet ist und der Einrastflansch (2422) zwischen der ersten Ablenkplatte (11) und der zweiten Ablenkplatte (3) eingeklemmt ist;
wobei der Steckerkörper (2) konfiguriert ist, mit einer Leiterplatte (25) verbunden zu sein, und mindestens ein Paar Leistungsanschlussstifte (21) und mehrere Datenanschlussstifte (22) umfasst und jedes Paar Leistungsanschlussstifte (21) ein Paar Unteranschlussstifte (211) umfasst, die in einer Aufwärts-/Abwärts-Richtung voneinander beabstandet sind;
wobei das Kapselungselement (24) konfiguriert ist, das mindestens eine Paar Leistungsanschlussstifte (21) und die mehreren Datenanschlussstifte (22) zu befestigen;
**dadurch gekennzeichnet, dass** mindestens einer des Paars Unteranschlussstifte (211) einen erweiterten Abschnitt (2111) umfasst und der erweiterte Abschnitt (2111) eine Querschnittfläche aufweist, die größer als die jedes der mehreren Datenanschlussstifte (22) des Steckerkörpers (2) ist, um eine Stromlast des mindestens einen des Paars Unteranschlussstifte (211) zu erhöhen;
eine Aussparung (2112) im erweiterten Abschnitt (2111) an einer Position definiert ist, die sich in der Nähe eines Endes des mindestens einen des Paars Unteranschlussstifte (211) befindet, der von der zweiten Ablenkplatte (3) entfernt ist.

2. Leistungsschnittstelle nach Anspruch 1, wobei eine Lücke (31) zwischen der zweiten Ablenkplatte (3) und der Steckerschale (1) definiert ist und eine Klebeschicht in der Lücke (31) angeordnet ist.

3. Leistungsschnittstelle nach einem der Ansprüche 1-2, wobei die zweite Ablenkplatte (3) in einer Umfangsrichtung des Steckerkörpers (2) verläuft.

4. Leistungsschnittstelle nach einem der Ansprüche 1-3, die mehrere zweite Ablenkplatten (3) umfasst.

5. Leistungsschnittstelle nach einem der Ansprüche 1-4, wobei die erste Ablenkplatte (11) in einer Umfangsrichtung des Steckerkörpers (2) verläuft.

6. Leistungsschnittstelle nach einem der Ansprüche 1-5, wobei ein Anschlagvorsprung (111) an einer Seitenwandfläche der ersten Ablenkplatte (11) angeordnet ist, die der zweiten Ablenkplatte (3) zugewandt ist, und der Anschlagvorsprung (111) mit dem Einrastflansch (2422) in Eingriff ist.

7. Leistungsschnittstelle nach einem der Ansprüche 1, wobei der erweiterte Abschnitt (2111) in einer Mitte des mindestens einen des Paars Unteranschlussstifte (211) angeordnet ist.

8. Verfahren zum Herstellen einer Leistungsschnittstelle für ein mobiles Endgerät, das Folgendes umfasst:
S10: Verarbeiten einer Steckerschale (1), wobei eine erste Ablenkplatte (11) in der Steckerschale (1) angeordnet wird;
S20: Montieren eines Steckerkörpers (2) in der Steckerschale (1), wobei der Steckerkörper (2) durch ein Kapselungselement (24) umwickelt ist; das Kapselungselement (24) einen ersten Kapselungsabschnitt (241) und einen zweiten Kapselungsabschnitt (242) umfasst und der erste Kapselungsabschnitt (241) und der zweite Kapselungsabschnitt (242) konfiguriert sind, miteinander zusammenzupassen und zusammenzuwirken; und ein Einrastflansch (2422), der auf den zweiten Kapselungsabschnitt (242) aufgebracht ist, am Steckerkörper (2) angeordnet ist; und
S30: Schweißen einer zweiten Ablenkplatte (3) an eine Innenfläche der Steckerschale (1), wobei die zweite Ablenkplatte (3) von der ersten Ablenkplatte (11) beabstandet ist und der Einrastflansch (2422) zwischen der ersten Ablenkplatte (11) und der zweiten Ablenkplatte (3) eingeklemmt ist;
wobei der Steckerkörper (2) konfiguriert ist, mit einer Leiterplatte (25) verbunden zu sein, und mindestens ein Paar Leistungsanschlussstifte (21) und mehrere Datenanschlussstifte (22) umfasst und jedes Paar Leistungsanschlussstifte (21) ein Paar Unteranschlussstifte (211) umfasst, die in einer Aufwärts-/Abwärts-Richtung voneinander beabstandet sind;
wobei das Kapselungselement (24) konfiguriert ist, das mindestens eine Paar Leistungsanschlussstifte (21) und die mehreren Datenanschlussstifte (22) zu befestigen;
**dadurch gekennzeichnet, dass** mindestens einer des Paars Unteranschlussstifte (211) einen erweiterten Abschnitt (2111) umfasst und der erweiterte Abschnitt (2111) eine Querschnittfläche aufweist, die größer als die jedes der mehreren Datenanschlussstifte (22) des Steckerkörpers (2) ist, um eine Stromlast des mindestens einen des Paars Unteranschlussstifte (211) zu erhöhen;
eine Aussparung (2112) im erweiterten Abschnitt (2111) bei einer Position definiert ist, die in der Nähe eines Endes des mindestens einen des Paars Unteranschlussstifte (211) ist, der von der zweiten Ablenkplatte (3) entfernt ist.

9. Verfahren nach Anspruch 8, wobei in S10 die Steckerschale (1) ein spritzgegossenes Teil ist und die erste Ablenkplatte (11) an der Innenfläche der Steckerschale (1) eingespritzt wird.

10. Verfahren nach einem der Ansprüche 8-9, wobei in S30 eine Lücke (31) zwischen der zweiten Ablenkplatte (3) und der Innenfläche der Steckerschale (1) definiert ist und das Verfahren ferner Folgendes umfasst:
S40: Anordnen einer Klebeschicht in der Lücke (31).

11. Mobiles Endgerät, **dadurch gekennzeichnet, dass** das mobile Endgerät die Leistungsschnittstelle nach einem der Ansprüche 1-7 umfasst.

12. Netzadapter für ein mobiles Endgerät, **dadurch gekennzeichnet, dass** der Netzadapter die Leistungsschnittstelle nach einem der Ansprüche 1-7 umfasst.

## Revendications

1. Interface d'alimentation électrique pour un terminal mobile, comprenant :
une coque de fiche (1), dans laquelle un premier déflecteur (11) est agencé dans la coque de fiche (1) ;
un élément d'encapsulation (24), dans laquelle l'élément d'encapsulation (24) comprend une première partie d'encapsulation (241) et une seconde partie d'encapsulation (242), et la première partie d'encapsulation (241) et la seconde partie d'encapsulation (242) sont configurées pour correspondre et coopérer l'une avec l'autre ;
un corps de fiche (2), agencé dans la coque de fiche (1) et entouré par l'élément d'encapsulation (24), dans laquelle une bride à ajustement par encliquetage (2422) disposée sur la seconde partie d'encapsulation (242) est agencée sur le corps de fiche (2) ; et
un second déflecteur (3), situé dans la coque de fiche (1) et raccordé à la coque de fiche (1), dans laquelle le second déflecteur (3) est espacé du premier déflecteur (11), la bride à ajustement par encliquetage (2422) est prise en sandwich entre le premier déflecteur (11) et le second déflecteur (3) ;
dans laquelle le corps de fiche (2) est configuré pour être raccordé à une carte de circuit imprimé (25) et comprend au moins une paire de broches d'alimentation électrique (21) et une pluralité de broches de données (22), et chaque paire de broches d'alimentation électrique (21) comprend une paire de sous-broches (211) espacées l'une de l'autre dans une direction haut-bas ;
l'élément d'encapsulation (24) est configuré pour fixer l'au moins une paire de broches d'alimentation électrique (21) et la pluralité de broches de données (22) ;
**caractérisée en ce qu'**au moins une de la paire de sous-broches (211) comprend une partie agrandie (2111), et la partie agrandie (2111) a une superficie de section transversale plus grande que celle de chacune de la pluralité de broches de données (22) du corps de fiche (2) pour augmenter une charge de courant de l'au moins une de la paire de sous-broches (211) ;
un évidement (2112) est défini dans la partie agrandie (2111) à une position qui est proche d'une extrémité de l'au moins une de la paire de sous-broches (211) éloignée du second déflecteur (3).

2. Interface d'alimentation électrique de la revendication 1, dans laquelle un espace (31) est défini entre le second déflecteur (3) et la coque de fiche (1), et une couche adhésive est agencée dans l'espace (31).

3. Interface d'alimentation électrique de l'une quelconque des revendications 1 à 2, dans laquelle le second déflecteur (3) s'étend le long d'une direction circonférentielle du corps de fiche (2).

4. Interface d'alimentation électrique de l'une quelconque des revendications 1 à 3, comprenant une pluralité de seconds déflecteurs (3).

5. Interface d'alimentation électrique de l'une quelconque des revendications de 1 à 4, dans laquelle le premier déflecteur (11) s'étend le long d'une direction circonférentielle du corps de fiche (2).

6. Interface d'alimentation électrique de l'une quelconque des revendications 1 à 5, dans laquelle une saillie d'arrêt (111) est agencée sur une face de paroi latérale du premier déflecteur (11) tournée vers le second déflecteur (3), et la saillie d'arrêt (111) est en prise avec la bride à ajustement par encliquetage (2422).

7. Interface d'alimentation électrique de l'une quelconque des revendications l, dans laquelle la partie agrandie (2111) est située dans un milieu de l'au moins une de la paire de sous-broches (211).

8. Procédé pour fabriquer une interface d'alimentation électrique pour un terminal mobile, comprenant :
S10 : le traitement d'une coque de fiche (1), dans lequel un premier déflecteur (11) est agencé dans la coque de fiche (1) ;
S20 : le montage d'un corps de fiche (2) dans la coque de fiche (1), dans lequel le corps de fiche (2) est entouré par un élément d'encapsulation (24) ; l'élément d'encapsulation (24) comprend une première partie d'encapsulation (241) et une seconde partie d'encapsulation (242), et la première partie d'encapsulation (241) et la seconde partie d'encapsulation (242) sont configurées pour correspondre et coopérer l'une avec l'autre ; une bride à ajustement par encliquetage (2422) disposée sur la seconde partie d'encapsulation (242) est agencée sur le corps de fiche (2) ; et
S30 : le soudage d'un second déflecteur (3) sur une face intérieure de la coque de fiche (1), dans lequel le second déflecteur (3) est espacé du premier déflecteur (11), la bride à ajustement par encliquetage (2422) est prise en sandwich entre le premier déflecteur (11) et le second déflecteur (3) ;
dans lequel le corps de fiche (2) est configuré pour être raccordé à une carte de circuit imprimé (25) et comprend au moins une paire de broches d'alimentation électrique (21) et une pluralité de broches de données (22), et chaque paire de broches d'alimentation électrique (21) comprend une paire de sous-broches (211) espacées l'une de l'autre dans une direction haut-bas ; l'élément d'encapsulation (24) est configuré pour fixer l'au moins une paire de broches d'alimentation électrique (21) et la pluralité de broches de données (22) ;
**caractérisé en ce qu'**au moins une de la paire de sous-broches (211) comprend une partie agrandie (2111), et la partie agrandie (2111) a une superficie de section transversale plus grande que celle de chacun de la pluralité de broches de données (22) du corps de fiche (2) pour augmenter une charge de courant de l'au moins une de la paire de sous-broches (211) ;
un évidement (2112) est défini dans la partie agrandie (2111) à une position qui est proche d'une extrémité de l'au moins une de la paire de sous-broches (211) éloignée du second déflecteur (3).

9. Procédé de la revendication 8, dans lequel, à l'étape S10, la coque de fiche (1) est une pièce moulée par injection, et le premier déflecteur (11) est injecté sur la face intérieure de la coque de fiche (1).

10. Procédé de l'une quelconque des revendications 8 et 9, dans lequel à l'étape S30, un espace (31) est défini entre le second déflecteur (3) et la face intérieure de la coque de fiche (1), le procédé comprend en outre :
S40 : l'agencement d'une couche adhésive dans l'espace (31).

11. Terminal mobile, **caractérisé en ce que** le terminal mobile comprend l'interface d'alimentation électrique de l'une quelconque des revendications 1 à 7.

12. Adaptateur d'alimentation électrique pour un terminal mobile, **caractérisé en ce que** l'adaptateur d'alimentation électrique comprend l'interface d'alimentation électrique de l'une quelconque des revendications 1 à 7.
